# EUROPÄISCHE PATENTSCHRIFT

(11) **EP 2 768 012 B1**
(45) Veröffentlichungstag und Bekanntmachung des Hinweises auf die Patenterteilung: **28.06.2017**
(21) Anmeldenummer: 13189125.1
(22) Anmeldetag: 17.10.2013
(51) Int. Cl.: H01L 21/02, H01L 21/78, B23K 15/00, B23K 15/08, B28D 5/04, H01L 21/263, C23C 14/30, C23C 14/24

(54) **Verfahren zum Ablösen eines scheibenförmigen Einkristalls von einem Grundkörper unter Anwendung eines Elektrostrahles**
Method of detaching a disc-shaped single crystal from a base body using an electron beam
Procédé de séparation d'un monocristal en forme de disque d'un corps de base utilisant un faisceau d'électrons

(30) Priorität: 30.01.2013 DE 102013201510
(43) Veröffentlichungstag der Anmeldung: 20.08.2014
(73) Patentinhaber: Fraunhofer-ges. zur Förderung der Angewandten Forschung E.V., 80686 München (DE)
(72) Erfinder: Temmler, Dietmar, 01109 Dresden (DE); Bedrich, Karl, 01099 Dresden (DE); Saager, Stefan, 01069 Dresden (DE)

(56) Entgegenhaltungen:
- JP-A- 2001 341 122
- JP-A- 2006 245 498
- US-A1- 2008 188 011
- US-A1- 2009 056 513
- US-A1- 2010 055 874

## Beschreibung

Die Erfindung betrifft ein Verfahren zum Ablösen einer einkristallinen Schicht gemäß dem Oberbegriff des Anspruchs 1. Derartige scheibenförmige Einkristalle aus einem Halbleitermaterial, auch Wafer oder Folie genannt, sind für mikroelektronische, sensorische, mikromechanische und photovoltaische Applikationen geeignet.

### Stand der Technik

Es sind verschiedene Verfahren zum Herstellen dünner einkristalliner Halbleiterwafer bekannt, bei denen ein einkristalliner Halbleiteringot als Ausgangsmaterial dient, von dem scheibenförmige Wafer abgetrennt werden.

Bei einem bekannten Verfahren werden die Wafer mittels Drahtsägeverfahren vom Halbleiterkristall abgetrennt (D. Heppner, R. Sueldia, A. Daridon, P. M. Nasch, M. Yin "New cost saving c-Si PV wafer slicing process by advanced wire technology", Proceedings 26th European Photovoltaic Solar Energy Conference, 5.-9. September 2011, Hamburg, Seiten 949-955). Nachteilig wirkt sich hierbei aus, dass beim Sägen bis zu 50 % des Halbleiterkristalls als Schnittverluste verloren gehen. Außerdem weisen die hierbei hergestellten Wafer eine relativ hohe Oberflächenrauigkeit auf, die eine Nachbehandlung der Oberflächen erforderlich macht und die Bruchfestigkeit des Wafers mindert.

Ein weiteres Verfahren besteht darin, Ionen (oftmals Wasserstoff Ionen) in eine Randschicht eines Halbleiterkristalls zu implantieren und anschließend die scheibenförmige Randschicht oberhalb des Maximums des Implantationsprofils mittels eines thermischen Schocks vom Halbleiterkristall abzusprengen (F. Henley, S. Kang, A. Brailove, A. Fujisaka "Kerf-free wafering for high-volume, high-efficiency c-Si cell", Proceedings 26th European Photovoltaic Solar Energy Conference, 5.-9. September 2011, Hamburg, Seiten 971-978). Diese Vorgehensweise erfordert einen hohen apparativen Aufwand mit hohem Flächen- / Raumbedarf, bei dem auch noch ausreichender Strahlenschutz gewährleistet werden muss. Nachteilig wirkt sich außerdem aus, dass die Wafer beim thermischen Schock mit einer hohen und für das Halbleitermaterial oftmals kritischen Prozesstemperatur beaufschlagt werden, so dass Kristalldefekte generiert werden.

Durch Konfektionierverluste des Einkristalls vor dem "smart cut" Abspalt-Prozess liegt die Materialausnutzung zudem deutlich unter 100%.

Für das Abspalten eines Wafers von einem Halbleiterkristall ist des Weiteren ein Verfahren bekannt, bei dem auf einer ebenen Oberfläche des Halbleiterkristalls eine Schicht mit einer hohen intrinsischen mechanischen Spannung und/oder einer großen Differenz zum thermischen Ausdehnungskoeffizienten des Ingotmaterials aufgetragen wird, so dass die abgeschiedene Schicht und eine definierte Dicke des Ingotmaterials bei einer nachfolgenden Temperaturbehandlung abgesprengt werden (R. A. Rao, L. Mathew, S. Saha, S. Smith, D. Sarkar, R. Garcia, R. Stout, A. Gurmu, D. Ahn, D. Xu, D. Jawarani, E. Onyegam, M. Hilali, S. Banerjee, J. Fossum "A novel low cost 25 µm thin exfoliated monocrystalline Si solar cell technology", Proceedings 26th European Photovoltaic Solar Energy Conference, 5.-9. September 2011, Hamburg, Seiten 2439-2442), Basis für den Oberbegriff des Anspruchs 1. Dieses Verfahren ist für Waferdicken kleiner 50 µm nicht geeignet. Die damit hergestellten Wafer weisen außerdem eine relativ hohe Oberflächenrauigkeit und Inhomogenitäten hinsichtlich Waferdicke auf.

Bei einem anderen bekannten Verfahren wird die Oberfläche eines Silizium-Wafers einem elektrochemischen Ätzprozess ausgesetzt, wodurch eine poröse Silizium-Oberflächenschicht entsteht, die später als Sollbruchstelle fungiert. Mit einem bekannten Verfahrensschritt der chemischen Schichtabscheidung (CVD) wächst auf der porösen Schicht anschließend eine geschlossene Epitaxie-Schicht aus Halbleitermaterial auf, welche in einem abschließenden Verfahrensschritt durch Bruch der porösen Schicht abgelöst wird (M. T. Hessmann, T. Kunz, I. Burkert, N. Gawehns, L. Schaefer, B. Meidel, R. Auer, C. J. Brabec "Laser welding of 50 micrometer thick monocrystalline silicon wafers", Proceedings 26th European Photovoltaic Solar Energy Conference, 5.-9. September 2011, Hamburg, Seiten 2825-2828). Diesem Verfahren haftet der Nachteil an, dass insbesondere das Aufwachsen der Epitaxie-Schicht sehr preisintensiv ist.

### Aufgabenstellung

Der Erfindung liegt daher das technische Problem zugrunde, ein Verfahren zu schaffen, mittels dem die Nachteile aus dem Stand der Technik überwunden werden. Insbesondere sollen mit dem erfindungsgemäßen Verfahren scheibenförmige Einkristalle mit geringer Oberflächenrauigkeit, mit gleichbleibender Scheibendicke kleiner 50 µm herstellbar sein.

Die Lösung des technischen Problems ergibt sich durch das Verfahren mit den Schritten/ Merkmalen des Patentanspruchs 1. Weitere vorteilhafte Ausgestaltungen der Erfindung ergeben sich aus den abhängigen Ansprüchen.

Der von einer seitlichen Begrenzung der ebenen Oberfläche des Grundkörpers beginnende, über den gesamten Querschnitt des Grundkörpers linienförmig geführte Ablöseprozess des scheibenförmigen Einkristalls ist ein spezieller, erfindungsgemäßer Elektronenstrahlprozess, bei dem ein fokussierter Elektronenstrahl die ebene Oberfläche des Grundkörpers abrastert. Das Abrastern der Oberfläche des Grundkörpers erfolgt dabei vorzugsweise mit einem optimierten zeitlich-räumlichen Strahlführungsmuster. Ein solcher Elektronenstrahl ist ein geeignetes Werkzeug, um eine hinreichende Energiemenge in eine definierte, der späteren Waferdicke entsprechende Tiefenregion eines Halbleiterkörpers einzutragen, die dort aufgrund eines lokal begrenzten, in Tiefenrichtung inhomogenen Temperaturfeldes mechanische Spannungen im Halbleitermaterial verursacht, die bei entsprechender Stärke zum Abplatzen des Wafers vom Halbleitermaterial führt.

Das Deponieren der Elektronenstrahlenergie in der Tiefe entsprechend der gewünschten Waferdicke nutzt dabei die Tatsache, dass die Eindringtiefe des Elektronenstrahls, bestimmt durch Beschleunigungsspannung und Dichte des Halbleitermaterials, bei etwa 1/3 der Elektronen-Eindringtiefe ein deutliches Maximum der Energiedichteverteilung aufweist. Für Silizium (2.336 g/cm³) ergeben sich beispielsweise bei 60 kV, 100 kV, bzw. 200 kV Elektronen-Eindringtiefen von 42 µm, 85 µm bzw. 214 µm und damit Tiefen des Maximums der Energiedichteverteilung von 14 µm, 28 µm bzw. 71 µm.

Das linienförmige Abrastern einer ebenen Oberfläche eines Halbleitereinkristalls, beginnend an einer Seite einer ebenen Einkristalloberfläche hin zur gegenüberliegenden Seite der ebenen Einkristalloberfläche, mit einem Elektronenstrahl gleichbleibender Eindringtiefe führt so zum Ablösen eines scheibenförmigen Einkristalls.

Die Steuerung des Elektronenstrahls, sein Vorschub in Richtung der fortlaufenden Ablösung des scheibenförmigen Einkristalls und seine Energie werden dabei optimal auf das Material eines jeweiligen Grundkörpers und die Eindringtiefe des Elektronenstrahls entsprechend der gewünschten Dicke des scheibenförmigen Einkristalls eingestellt, um den herzustellenden Halbleiterwafer durch geringen, für den Ablöseprozess aber ausreichenden mechanischen Stress und bei niedrigem Temperaturbudget, nahe dem notwendigen Minimum, schonend, d. h. ohne Defektgeneration, vom Grundkörper abzulösen.

Für das linienhafte Abspalten des Halbleiterwafers von der Oberfläche des Halbleiterkristalls wird mittels einer Elektronenstrahlkanone eine Elektronenstrahl-Linie erzeugt, die senkrecht dazu über den Querschnitt der Halbleiteranordnung, in Ausbreitungsrichtung der Schichtablösung geführt wird.

Dazu sind im Wesentlichen zwei Typen von Elektronenstrahlkanonen einsetzbar:
- eine Elektronenstrahl-Linienquelle, bei der die Breite der Halbleiteranordnung mit einem hochfokussierten, linienhaften Elektronenstrahl hoher Homogenität bestrahlt wird, wobei die Elektronenstrahl-Linie, ausgehend von der Kante der Halbleiteranordnung mit einem Initialspalt mit einer dem Abspaltprozess angepassten Geschwindigkeit über den Querschnitt der Halbleiteranordnung geführt wird,
- eine Elektronenstrahl-Punktquelle mit elektromagnetischer Strahlführung, bei der die Halbleiteranordnung mit einem hochfokussierten, punktförmigen Elektronenstrahl bestrahlt wird, wobei der Elektronenstrahl-Spot, ausgehend von der Kante der Halbleiteranordnung mit einem Initialspalt mit sehr hohen Geschwindigkeit (Scanfrequenz > 50 kHz), über die Breite der Halbleiteranordnung geführt wird, während die so erzeugte "Linie" senkrecht dazu mit einer dem Abspaltprozess angepassten, geringeren Geschwindigkeit über den Querschnitt der Halbleiteranordnung fährt.

Zum definierten Ablösen eines scheibenförmigen Einkristalls bei einer vorgegebenen Scheibendicke wird vor dem Abspaltprozess vorzugsweise ein Initialspalt im Grundkörper eingebracht, mit einem Abstand entsprechend der Scheibendicke des scheibenförmigen Einkristalls von der ebenen Oberfläche der Halbleiteranordnung und parallel zu dieser. Da ein solcher schmaler Initialspalt eine gewisse Spaltbreite aufweist, ist es genau genommen die Mittellinie des Initialspaltes, die mit dem Maß der Scheibendicke des scheibenförmigen Einkristalls von der ebenen Oberfläche beabstandet wird.

Ein solcher Initialspalt kann mit mechanischen Mitteln wie beispielsweise einer Drahtsäge in den Grundkörper eingebracht werden. Alternativ kann dieser aber auch mittels eines Lasers, mittels lonenstrahl- oder Elektronenstrahl-unterstütztem Ätzen in den Grundkörper eingebracht werden.

Das Abrastern der ebenen Oberfläche des Grundkörpers mit einem Elektronenstrahl wird an der Seite der ebenen Oberfläche begonnen, an der der Initialspalt im Grundkörper eingebracht wurde und endet an der gegenüberliegenden Seite des Grundkörpers. Dabei wird der Elektronenstrahl vorzugsweise linienförmig in Richtung der Längenausdehnung des Initialspaltes ausgebildet und mit einem Vorschub senkrecht zur Längenausdehnung des Initialspaltes geführt. Das erfindungsgemäße Verfahren definiert das Ablösen einer einkristallinen Schicht, die auf einem einkristallinen Substrat abgeschieden wurde, abzulösen. Auch hier wird ein Initialspalt an einer Seite des Grundkörpers, umfassend das Substrat und die Schicht, eingebracht und zwar genau an der Grenzfläche von Substrat und Schicht. Die Eindringtiefe des Elektronenstrahls, mit dem die Oberfläche der Schicht anschließend mit einer Ablenkfrequenz größer 50 kHz abgerastert wird, wird derart eingestellt, dass das Maximum der Energie des Elektronenstrahls auf der Grenzfläche von Substrat und Schicht eingetragen wird. Die hierfür erforderliche Eindringtiefe des Elektronenstrahls ist auch in diesem Fall in Abhängigkeit von der Beschleunigungsspannung, und von der Dichte des Materials der Schicht berechenbar und einstellbar.

Da mit einem Elektronenstrahl die Energie in einen Grundkörper lokal begrenzt eingetragen werden kann, ist das erfindungsgemäße Verfahren mit einer geringeren thermischen Belastung für den Grundkörper und den abzulösenden scheibenförmigen Einkristall verbunden als bekannte Verfahren aus dem Stand der Technik. Dieser schonende Ablöseprozess bringt daher scheibenförmige Einkristalle mit hoher Kristallqualität hervor. Diese hohe Kristallqualität liegt auch darin begründet, dass eine hochreine Kristallanordnung als Ausgangsmaterial verwendet werden kann, die nicht noch mit anderen Elementen dotiert werden muss, wie bei bekannten Verfahren. Die abgelösten scheibenförmigen Einkristalle weisen eine geringe Rauigkeit und eine geringe Dickenvariation durch eine präzise Steuerung der Strahlenergieverteilung in der Tiefe des Grundkörpers auf. Weiterhin zeichnet sich das erfindungsgemäße Verfahren durch eine hohe mechanische Stabilität der erzeugten Wafer infolge des schonenden Ablöseprozesses aus, bei dem nur ein sehr geringer Anteil an Waferbruch entsteht. Ein weiterer Vorteil liegt in der sehr hohen Materialausnutzung des Ausgangsmaterials begründet, bei dem nahezu keine Konfektionierverluste auftreten. Des Weiteren ist das erfindungsgemäße Verfahren auch zum Herstellen von Wafern mit einer Dicke von unter 50 µm geeignet.

### Ausführungsbeispiel

Die vorliegende Erfindung wird nachfolgend anhand von Ausführungsbeispielen näher erläutert. Die Fig. zeigen:
- Fig. 1: eine schematische Darstellung einer Vorrichtung zum Ablösen einer Waferscheibe von einem Kristallstab;
- Fig. 2: eine schematische Darstellung einer Vorrichtung zum Ablösen einer Schicht von einem Substrat.

Für eine photovoltaische Applikation sollen 30 µm dicke, scheibenförmige Silizium-Einkristalle hergestellt werden. Als Ausgangsmaterial hierfür dient ein konventionell hergestellter, <100>-orientierter, 200 mm CZ-Silizium-Kristall. Dieser wird kristallografisch hochgenau ausgerichtet, die Kristallenden durch Trennsägen abgetrennt und die Seitenflächen durch Trennsägen derart bearbeitet, dass ein quaderförmiger Einkristallstab mit pseudo-quadratischem Querschnitt von 156 mm x 156 mm entsteht. Danach werden die trenngesägten Oberflächen des Kristallstabs überätzt und mechanisch durch Läppen und/oder Polieren nachbearbeitet.

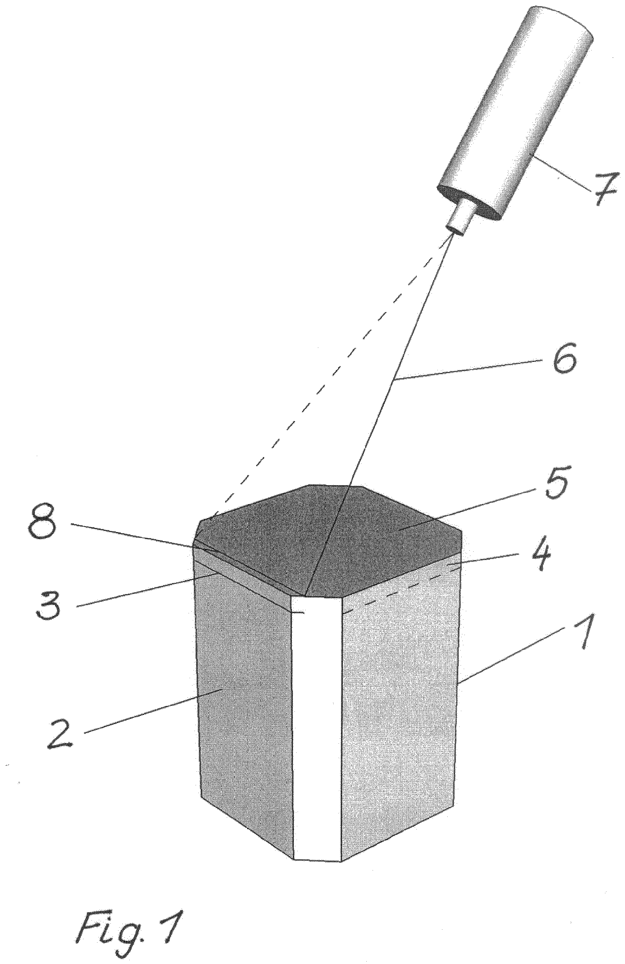

Fig. 1 zeigt in einer schematischen Darstellung einen solchen als Grundkörper fungierenden Kristallstab 1, der in eine (in Fig. 1 nicht dargestellte) Hochvakuumstation für den erfindungsgemäßen Wafer-Abtrennprozess eingeschleust wurde. Nach exakter kristallografischer Ausrichtung des Kristallstabs 1 wird eine Seitenfläche 2 mittels lonenstrahlätzen (FIB) in ihrer gesamten Breite mit einem Initialspalt 3 von 5 µm Breite und 10 µm Tiefe versehen. Die Mittellinie des Initialspalts 3 liegt entsprechend der Dicke des abzutrennenden Wafers 4 30 µm unter der polierten Stirnfläche 5 des Kristallstabs 1 und ist exakt parallel zu Stirnfläche 5 ausgerichtet.

Damit ist der Kristallstab 1 für den Wafer-Abtrennprozess vorbereitet. Dieser erfolgt mit einem fokussierten Elektronenstrahl 6 einer axialen Elektronenstrahlkanone mit elektromagnetischer Strahlführung hoher Scanfrequenz (>50 kHz) mit optimiertem, zeitlich-räumlichen Strahlführungsmuster auf der Stirnfläche 5 des Kristallstabs 1.

Der Abtrennprozess wird von der mit dem Initialspalt 3 versehenen Seite 2 des Kristallstabs 1 beginnend, sukzessiv über die gesamte Stirnfläche 5 des Kristallstabs 1 geführt. Dabei wird der Elektronenstrahl 6 linienförmig in Richtung der Längsausdehnung des Initialspaltes 3 abgelenkt und überstreicht somit eine Linie 8 auf der Stirnfläche 5. Zusätzlich erhält der Elektronenstrahl 3 einen Vorschub senkrecht zur Längsausdehnung des Initialspaltes 3, bis die gesamte Stirnfläche 5 des Kristallstabs 1 abgerastert ist. Die Vorschubgeschwindigkeit des Elektronenstrahls 6 ist dabei auf die Ausbreitungsgeschwindigkeit des Ablösens des scheibenförmigen Wafers 4 (die durch die Materialparameter des Kristallstabs 1 bestimmt ist) abgestimmt. Die hierfür optimale Vorschubgeschwindigkeit für den Elektronenstrahl 6 wurde zuvor in Laborversuchen ermittelt.

Die Eindringtiefe des Elektronenstrahls 6 in den Silizium Kristallstab 1 wurde in Abhängigkeit von der Beschleunigungsspannung derart eingestellt, dass das Maximum der Energie des Elektronenstrahls 6 in einer Tiefe von 30 µm in den Kristallstab 1 eingetragen wird. Auf diese Weise wird, ausgehend vom Initialspalt 3 ein Siliziumwafer 4 mit einer Waferdicke von 30 µm vom Kristallstab 1 abgetrennt und in einem Magazin innerhalb der Hochvakuumstation zwischengelagert, ehe er mit weiteren dünnen Wafern ausgeschleust und zur Herstellung der finalen Oberflächengüte nachbearbeitet wird. Der Kristallstab 1 wird nach Einbringen eines weiteren Initialspalts 3 mit einem erneuten Wafer-Ablöseprozess bearbeitet.

Wie zuvor schon einmal dargelegt wurde, kann mittels des Verfahrens nicht nur ein Wafer von einem Kristallstab sondern auch eine Schicht von einem Substrat abgelöst werden.

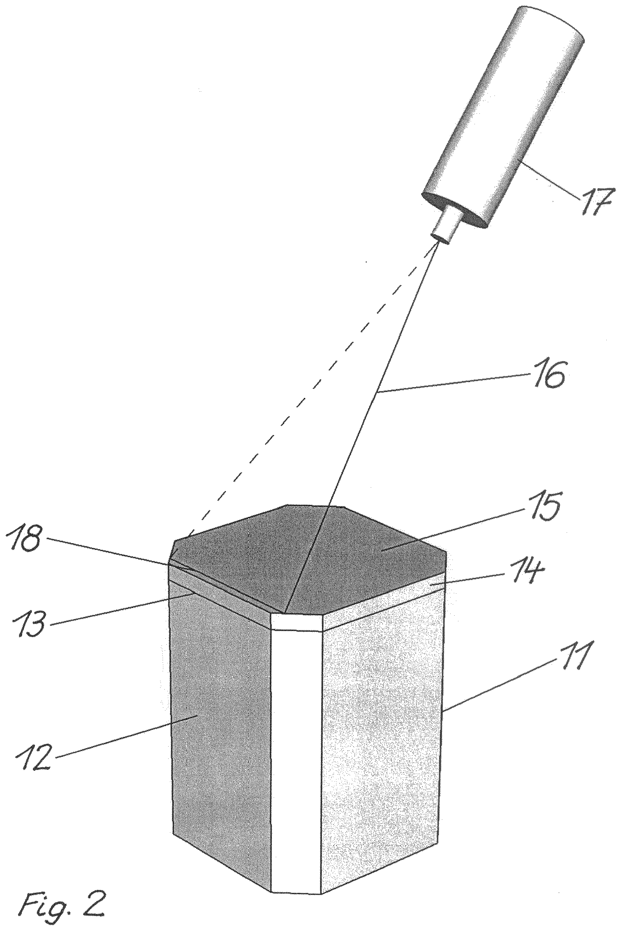

In Fig. 2 ist ein Grundkörper, umfassend ein als Saphirkristall ausgebildetes Substrat 11, auf dem eine einkristalline Siliziumschicht 14 abgeschieden wurde, schematisch dargestellt. Mittels des erfindungsgemäßen Verfahrens soll die einkristalline Siliziumschicht 14 vom Substrat 11 abgelöst werden. Dazu wird der Grundkörper zunächst in eine in Fig. 2 nicht dargestellte Hochvakuumstation eingeschleust. Nach exakter kristallografischer Ausrichtung des Grundkörpers wird eine Seitenfläche 12 mittels Ionenstrahlätzen (FIB) in ihrer gesamten Breite mit einem Initialspalt 13 von 6 µm Breite und 12 µm Tiefe versehen. Die Mittellinie des Initialspalts 13 liegt exakt an der Grenzfläche zwischen dem Substrat 11 und der einkristallinen Siliziumschicht 14.

Damit ist der Grundkörper für den Schicht-Abtrennprozess vorbereitet. Dieser erfolgt mit einem fokussierten Elektronenstrahl 16 einer axialen Elektronenstrahlkanone 17 mit elektromagnetischer Strahlführung hoher Scanfrequenz (>50 kHz) mit optimiertem, zeitlich-räumlichen Strahlführungsmuster auf der Oberfläche 15 der einkristallinen Siliziumschicht 14.

Der Abtrennprozess wird von der mit dem Initialspalt 13 versehenen Seite 12 des Grundkörpers beginnend, sukzessiv über die gesamte Oberfläche 15 der einkristallinen Siliziumschicht 14 geführt. Dabei wird der Elektronenstrahl 16 linienförmig in Richtung der Längsausdehnung des Initialspaltes 13 abgelenkt und überstreicht somit eine Linie 18 auf der Oberfläche 15. Zusätzlich erhält der Elektronenstrahl 13 einen Vorschub senkrecht zur Längsausdehnung des Initialspaltes 13, bis die gesamte Oberfläche 15 der einkristallinen Siliziumschicht 14 abgerastert ist. Die Vorschubgeschwindigkeit des Elektronenstrahls 16 ist dabei auf die Ausbreitungsgeschwindigkeit des Ablösens der einkristallinen Schicht 14 abgestimmt. Die hierfür optimale Vorschubgeschwindigkeit für den Elektronenstrahl 16 wurde zuvor in Laborversuchen ermittelt.

Die Eindringtiefe des Elektronenstrahls 16 in den Grundkörper wurde in Abhängigkeit von der Beschleunigungsspannung, dem Strahlstrom und der Strahlablenkgeschwindigkeit derart eingestellt, dass das Maximum der Energie des Elektronenstrahls 16 in der Grenzfläche zwischen Substrat 11 und einkristalliner Schicht 14 eingetragen wird. Auf diese Weise wird, ausgehend vom Initialspalt 13 die einkristalline Siliziumschicht 14 abgetrennt.

## Patentansprüche

1. Verfahren zum Ablösen einer einkristallinen Schicht (14), die auf einem einkristallinen Substrat (11) abgeschieden wurde, wobei das einkristalline Substrat (11) und die darauf abgeschiedene einkristalline Schicht (14) einen Grundkörper bilden und wobei der Grundkörper zumindest in dem Bereich, in welchem die einkristalline Schicht (14) abgelöst werden soll, eine ebene Oberfläche (15) aufweist, **gekennzeichnet durch** linienförmiges Abrastern der ebenen Oberfläche (15) des Grundkörpers mit einem fokussierten Elektronenstahl (16), beginnend an einer Seite (12) des Grundkörpers, und endend an dessen gegenüberliegender Seite.

2. Verfahren nach Anspruch 1, **dadurch gekennzeichnet, dass** die Beschleunigungsspannung, der elektrische Strom und die Ablenkgeschwindigkeit des Elektronenstrahls (16) derart eingestellt werden, dass der für den Abspaltprozess notwendige Energieeintrag des Elektronenstrahls (16) in einer Tiefe des Grundkörpers erfolgt, die der Dicke der einkristallinen Schicht (14) entspricht.

3. Verfahren nach Anspruch 1, **dadurch gekennzeichnet, dass** der Elektronenstrahl (16) durch Verwendung einer Elektronenstrahl-Linienquelle mit linienförmigem Fokus ausgebildet wird und mit einem Vorschub senkrecht zur Längenausdehnung der Elektronenstrahl-Linie über die ebene Oberfläche (15) des Grundkörpers geführt wird.

4. Verfahren nach Anspruch 1, **dadurch gekennzeichnet, dass** der Elektronenstrahl (16) durch Verwendung einer Elektronenstrahl-Punktquelle mit elektromagnetischer Strahlführung mit hoch-fokussiertem, punktförmigem Fokus ausgebildet wird.

5. Verfahren nach Anspruch 1, **dadurch gekennzeichnet, dass** vor Beginn des linienförmigen Ablöseprozesses ein Initialspalt (3) an der Grenzfläche von einkristalliner Schicht (14) und einkristallinem Substrat (11) an der Seite (12) des Grundkörpers eingebracht wird, an der der Ablöseprozess beginnt.

6. Verfahren nach Anspruch 5, **dadurch gekennzeichnet, dass** der Initialspalt mechanisch und insbesondere durch Ritzen oder Drahtsägen in den Grundkörper eingebracht wird.

7. Verfahren nach Anspruch 5, **dadurch gekennzeichnet, dass** der Initialspalt (13) durch Direktstrukturierungsverfahren mittels Laser, lonenstrahl- oder Elektronenstrahlunterstütztes Ätzen in den Grundkörper eingebracht wird.

8. Verfahren nach Anspruch 1, **dadurch gekennzeichnet, dass** ein Grundkörper verwendet wird, bei welchem das einkristalline Substrat (11) als Saphirkristall ausgebildet wird, und dass die einkristallinen Schicht (14) als Siliziumschicht ausgebildet wird.

## Claims

1. Method for detaching a monocrystalline layer (14), which was deposited on a monocrystalline substrate (11), wherein the monocrystalline substrate (11) and the monocrystalline layer (14) that is deposited thereon form a main body and wherein the main body has a planar surface (15) at least in the region in which the monocrystalline layer (14) is intended to be detached, **characterized by** line-shaped scanning of the planar surface (15) of the main body with a focused electron beam (16), beginning on one side (12) of the main body and ending on the opposite side thereof.

2. Method according to Claim 1, **characterized in that** the accelerating voltage, the electric current and the deflection rate of the electron beam (16) are adjusted such that the energy input of the electron beam (16), which is necessary for the cleavage process, takes place at a depth of the main body that corresponds to the thickness of the monocrystalline layer (14).

3. Method according to Claim 1, **characterized in that** the electron beam (16) is formed by way of using an electron beam line source with a line-shaped focus and is guided over the planar surface (15) of the main body with a forward movement perpendicular to the length extent of the electron beam line.

4. Method according to Claim 1, **characterized in that** the electron beam (16) is formed by way of using an electron beam point source with an electromagnetic beam guidance with a highly focused, point-shaped focus.

5. Method according to Claim 1, **characterized in that** before the line-shaped detachment process begins, an initial cleavage (3) is introduced at the boundary surface of the monocrystalline layer (14) and the monocrystalline substrate (11) at that side (12) of the main body at which the detachment process begins.

6. Method according to Claim 5, **characterized in that** the initial cleavage is introduced into the main body mechanically and in particular by scoring or by wire saw.

7. Method according to Claim 5, **characterized in that** the initial cleavage (13) is introduced into the main body by way of direct structuring methods using laser, ion-beam-assisted etching or electron-beam-assisted etching.

8. Method according to Claim 1, **characterized in that** a main body is used in which the monocrystalline substrate (11) is configured in the form of a sapphire crystal and **in that** the monocrystalline layer (14) is configured in the form of a silicon layer.

## Revendications

1. Procédé de séparation d'une couche monocristalline (14), qui a été déposée sur un substrat monocristallin (11), le substrat monocristallin (11) et la couche monocristalline (14) déposée sur celui-ci formant un corps de base et le corps de base présentant une surface plane (15) au moins dans la zone dans laquelle la couche monocristalline (14) doit être séparée, **caractérisé par** un balayage linéaire de la surface plane (15) du corps de base avec un faisceau d'électrons focalisé (16), en commençant sur un côté (12) du corps de base et en finissant sur son côté opposé.

2. Procédé selon la revendication 1, **caractérisé en ce que** la tension d'accélération, le courant électrique et la vitesse de balayage du faisceau d'électrons (16) sont ajustés de sorte que l'apport d'énergie du faisceau d'électrons (16) nécessaire pour le procédé de séparation ait lieu à une profondeur du corps de base qui correspond à l'épaisseur de la couche monocristalline (14).

3. Procédé selon la revendication 1, **caractérisé en ce que** le faisceau d'électrons (16) est formé en utilisant une source linéaire de faisceau d'électrons à focalisation linéaire et conduit sur la surface plane (15) du corps de base avec une avance perpendiculairement à l'extension longitudinale de la ligne de faisceau d'électrons.

4. Procédé selon la revendication 1, **caractérisé en ce que** le faisceau d'électrons (16) est formé en utilisant une source ponctuelle de faisceau d'électrons à guidage électromagnétique du faisceau avec une focalisation ponctuelle hautement focalisée.

5. Procédé selon la revendication 1, **caractérisé en ce qu'**avant le début du procédé de séparation linéaire, une fente initiale (3) est introduite sur l'interface de la couche monocristalline (14) et du substrat monocristallin (11) sur le côté (12) du corps de base sur lequel le procédé de séparation commence.

6. Procédé selon la revendication 5, **caractérisé en ce que** la fente initiale est introduite mécaniquement et notamment par rayure ou sciage au fil dans le corps de base.

7. Procédé selon la revendication 5, **caractérisé en ce que** la fente initiale (13) est introduite par un procédé de structuration directe par gravure laser ou supportée par faisceau d'ions ou faisceau d'électrons dans le corps de base.

8. Procédé selon la revendication 1, **caractérisé en ce qu'**un corps de base dans lequel le substrat monocristallin (11) est configuré sous la forme d'un cristal de saphir est utilisé et **en ce que** la couche monocristalline (14) est configurée sous la forme d'une couche de silicium.
